# EUROPÄISCHE PATENTSCHRIFT

(11) **EP 1 794 603 B1**
(45) Veröffentlichungstag und Bekanntmachung des Hinweises auf die Patenterteilung: **07.11.2018**
(21) Anmeldenummer: 05797327.3
(22) Anmeldetag: 30.09.2005
(51) Int. Cl.: G01R 29/04

(54) **BEWERTUNGSGLEICHRICHTER FÜR PULSSTÖRUNGEN**
PULSE DISTURBANCE WEIGHTING RECTIFIER
REDRESSEUR D'EVALUATION DE PERTURBATIONS IMPULSIVES

(30) Priorität: 01.10.2004 DE 102004048004
(43) Veröffentlichungstag der Anmeldung: 13.06.2007
(73) Patentinhaber: Rohde & Schwarz GmbH & Co. KG, 81671 München (DE)
(72) Erfinder: STECHER, Manfred, 82541 Münsing (DE)
(74) Vertreter: Körfer, Thomas
(86) Internationale Anmeldenummer: PCT/EP2005/010608
(87) Internationale Veröffentlichungsnummer: WO 2006/037577

(56) Entgegenhaltungen:
- EP-A- 0 379 050
- DE-A1- 10 126 830
- US-A- 4 736 163
- STECHER M: "A weighting detector for the effect of interference on digital radiocommunication services" ELECTROMAGNETIC COMPATIBILITY, 2003. EMC '03. 2003 IEEE INTERNATIONAL SYMPOSIUM ON ISTANBUL, TURKEY 11-16 MAY 2003, PISCATAWAY, NJ, USA,IEEE, Bd. 1, 11. Mai 2003 (2003-05-11), Seiten 449-452, XP010795717 ISBN: 0-7803-7779-6
- STECHER M: "Weighting of interference according to its effect on digital communications services" ELECTROMAGNETIC COMPATIBILITY, 1998. 1998 IEEE INTERNATIONAL SYMPOSIUM ON DENVER, CO, USA 24-28 AUG. 1998, PISCATAWAY, NJ, USA,IEEE, US, Bd. 1, 24. August 1998 (1998-08-24), Seiten 69-73, XP010324149 ISBN: 0-7803-5015-4
- KNOBLOCH A ET AL: "Critical review of converting spectral data into prospective bit error rates" 2002 IEEE INTERNATIONAL SYMPOSIUM ON ELECTROMAGNETIC COMPATIBILITY. EMC. SYMPOSIUM RECORD. MINNEAPOLIS, MN, AUG. 19 - 23, 2002, INTERNATIONL SYMPOSIUM ON ELECTROMAGNETIC COMPATIBILITY, NEW YORK, NY : IEEE, US, Bd. VOL. 1 OF 2, 19. August 2002 (2002-08-19), Seiten 173-178, XP010603218 ISBN: 0-7803-7264-6

## Beschreibung

Die Erfindung betrifft eine Gleichrichterschaltung zum Bewerten von Pulsstörungen bezüglich ihres Einflusses auf digitale Funksysteme laut Oberbegriff des Hauptanspruches.

Ein Bewertungsgleichrichter dieser Art ist aus der DE 101 26 830 A1 bekannt. Es ist auch schon aus der DE 101 26 830 A1 bekannt, anstelle des Effektivwertgleichrichters einen Spitzenwertgleichrichter zu benutzen. Diese bekannten Bewertungsgleichrichter berücksichtigen zwar den Verlauf der Bewertungskurve oberhalb und unterhalb der Eckfrequenz, die für GSM beispielsweise bei 1 kHz liegt, es hat sich jedoch gezeigt, dass einige gemessene Pulsstör-Bewertungs-Verläufe bei hohen Pulsfrequenzen einen flachen Verlauf aufweisen und erst bei niedrigeren Pulsfrequenzen in einen Verlauf übergehen, der mit etwa 10 dB/Dekade ansteigt. Solche Pulsstör-Bewertungs-Verläufe werden daher von diesen bekannten Bewertungsgleichrichtern nicht optimal bewertet.

Es ist daher Aufgabe der Erfindung, einen Bewertungsgleichrichter für Pulsstörungen der eingangs erwähnten Art zu schaffen, der Pulsstörungen nicht nur oberhalb und unterhalb der erkannten Eckfrequenz richtig bewertet, sondern auch bei hohen Pulsfrequenzen.

Diese Aufgabe wird ausgehend von einer Gleichrichterschaltung laut Oberbegriff des Hauptanspruches durch dessen kennzeichnende Merkmale gelöst. Vorteilhafte Weiterbildungen ergeben sich aus den Unteransprüchen.

Durch die erfindungsgemäße Kombination der beiden bekannten Maßnahmen der eingangs erwähnten Art werden auch bei hohen Pulsfrequenzen beispielsweise über 100 kHz Pulsstörungen richtig bewertet.

Die Erfindung wird im Folgenden anhand schematischer Zeichnungen an einem Ausführungsbeispiel näher erläutert. In der Zeichnung zeigen:
- Fig. 1: das Prinzipschaltbild einer erfindungsgemäßen Gleichrichterschaltung;
- Fig. 2: den Bewertungsfaktor in Abhängigkeit von der Pulsfrequenz fₚ einer Gleichrichterschaltung nach Fig. 1 und zwar für verschiedene Impulsbreiten Wₚ.

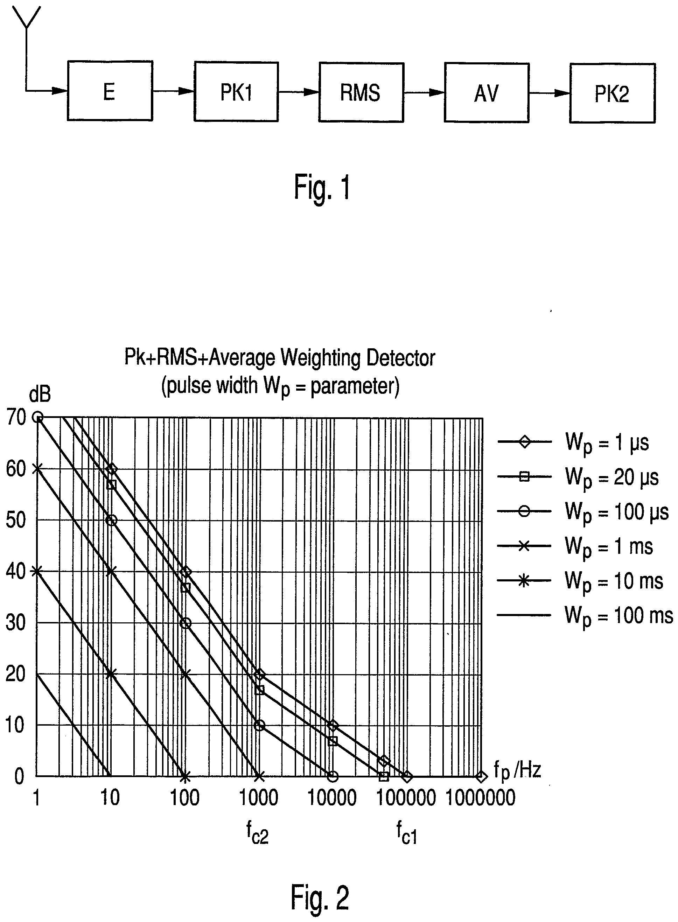

Fig. 1 zeigt das Prinzipschaltbild eines erfindungsgemäßen Bewertungsgleichrichters. Die zu untersuchende Hochfrequenz-Pulsstörung wird über eine beispielsweise nahe einem zu untersuchenden Kraftfahrzeug angeordnete Antenne einem Empfänger E zugeführt, dort in eine Zwischenfrequenz umgesetzt und gleichgerichtet. Die dadurch gewonnenen Hüllkurve der Hochfrequenz-Pulsstörung wird dann dem eigentlichen Bewertungsgleichrichter zugeführt, der gemäß der Erfindung aus einem ersten Spitzenwertgleichrichter PK1, einen nachfolgenden Effektivwertgleichrichters RMS und einem linearen Mittelwertgleichrichter AV besteht.

Der Spitzenwertgleichrichter PK1 besitzt eine maximale Messzeit T₁=1/f_{c1}, wobei f_{c1} zwischen 10 kHz und 500 kHz, vorzugsweise bei 100 kHz liegt.

Der nachfolgende Effektivwertgleichrichter RMS ist bezüglich seiner Integrationszeit T₂ in Abhängigkeit von der Eckfrequenz f_{c2}, zu T₂=1/f_{c2} begrenzt. Die Eckfrequenz f_{c2} liegt für GSM beispielsweise bei 1 kHz und unterhalb dieser bewertet der Effektivwertgleichrichter die Pulsstörungen zu hoch, wie dies ausführlich in DE 101 26 830 A1 beschrieben ist. Für GSM liegt die Eckfrequenz f_{c2} etwa zwischen 0,5 und 2 kHz. Es wurde jedoch auch schon festgestellt, dass diese Eckfrequenz bereits bei 5 Hz liegen kann. Die vorzugsweise benutzte Eckfrequenz von 1 kHz bedeutet eine Integrationszeit von 1 ms.

Der Effektivwertgleichrichter RMS bewertet in aufeinanderfolgenden Paketen mit der Dauer der Integrationszeit den Effektivwert der Pulsstörungen. Diese Effektivwert-Pakete werden anschließend im linearen Mittelwertgleichter AV gemittelt. Unterhalb der Eckfrequenz f_{c2} wirkt dieser lineare Mittelwertgleichrichter, so dass insgesamt eine Bewertungskurve gemäß Fig. 2 erreicht wird.

In Fig. 2 ist der Bewertungsfaktor in dB in Abhängigkeit von der Pulsfrequenz fₚ dargestellt, und zwar für verschiedene Impulsbreiten Wₚ. Eine erfindungsgemäße Kaskadenschaltung entspricht also in guter Näherung der theoretisch erkannten Bewertungskurve und vermeidet daher Fehlbewertungen. Der Spitzenwertgleichrichter PK 1 bewertet die Pulsstörungen oberhalb der Eckfrequenz f_{c1} mit 0 dB/Dekade, der anschließende Effektivwertgleichrichter RMS besitzt eine Bewertungskurven-Steilheit von etwa 10 dB/Dekade. Der drauffolgende lineare Mittelwertgleichrichter AV eine Bewertungskurve mit einer Steilheit von etwa 20 dB/Dekade und diese drei Kurven zusammen entsprechen damit in etwa der gewünschten Bewertungskurve. Am Ausgang des Mittelwertgleichrichters AV mit einer Zeitkonstante gemäß CISPR-Norm kann in an sich bekannter Weise noch ein Spitzenwertgleichrichter PK2 angeordnet sein, wie dies in DE 101 26 830 näher beschrieben ist. Die Zeitkonstante des linearen Mittelwertgleichrichters AV ist entsprechend der CISPR-Vorschrift mit mindestens 100 ms bemessen. Auch hierfür gilt das in der DE 101 26 830 A1 b
Beschriebene. Es ist nur dafür zu sorgen, dass die Messzeit des linearen Mittelwertgleichrichters größer als die Messzeit T₂ des Effektivwertgleichrichters ist.

## Patentansprüche

1. Gleichrichterschaltung zum Bewerten von Pulsstörungen bezüglich ihres Einflusses auf digitale Funksysteme mit einer Kaskadenschaltung eines Effektivwertgleichrichters (RMS) und eines linearen Mittelwertgleichrichters (AV),
**dadurch gekennzeichnet,**
**dass** vor dem Effektivwertgleichrichter (RMS) in Kaskade ein erster Spitzenwertgleichrichter (PK1) angeordnet ist.

2. Gleichrichterschaltung nach Anspruch 1,
**dadurch gekennzeichnet,**
**dass** die Integrationszeit T₂ des Effektivwertgleichrichters (RMS) auf einen Wert T₂=1/f_{c2} begrenzt ist, wobei f_{c2} die Eckfrequenz ist, unterhalb welcher der Effektivwertgleichrichter (RMS) die Pulsstörungen zu hoch bewertet.

3. Gleichrichterschaltung nach Anspruch 1 oder 2,
**dadurch gekennzeichnet,**
**dass** die maximale Messzeit T₁ des Spitzenwertgleichrichters (PK 1) T₁=1/f_{c1} ist, wobei f_{c1} die Eckfrequenz ist, oberhalb welcher der Pulsstör-Bewertungs-Verlauf konstant sein soll.

4. Gleichrichterschaltung nach Anspruch 1 oder 2,
**dadurch gekennzeichnet,**
**dass** für die Bewertung von Störungen zum Schutz von GSM-Systemen die Eckfrequenz (f_{c2}) zwischen 5 Hz und 2 kHz, vorzugsweise zu 1 kHz gewählt ist.

5. Gleichrichterschaltung nach einem der vorhergehenden Ansprüche,
**dadurch gekennzeichnet,**
**dass** am Ausgang des linearen Mittelwertgleichrichters (AV) mit einer Zeitkonstante gemäß CISPR-Norm ein zweiter Spitzenwertgleichrichter (PK2) angeordnet ist.

6. Gleichrichterschaltung nach einem der vorhergehenden Ansprüche,
**dadurch gekennzeichnet,**
**dass** die in Kaskade geschalteten Gleichrichter (PK1, RMS, AV, PK2) als Digitalschaltungen realisiert sind.

## Claims

1. Rectifier circuit for weighting of pulse disturbances with respect to their influence on digital radio systems, having an effective or rms value rectifier (RMS) and a linear average value rectifier (AV) connected in cascade,
**characterised in that**
a first peak value rectifier (PK1) is arranged connected in cascade upstream of the effective or rms value rectifier (RMS).

2. Rectifier circuit according to claim 1,
**characterised in that**
the integration time T₂ of the effective or rms value rectifier (RMS) is limited to a value T₂ = 1/f_{c2}, wherein f_{c2} is the cut-off frequency below which the effective or rms value rectifier (RMS) weights the pulse disturbances too highly.

3. Rectifier circuit according to claim 1 or 2,
**characterised in that**
the maximum measuring time T₁ of the peak value rectifier (PK1) is T₁ = 1/f_{c1}, wherein f_{c1} is the cut-off frequency above which the pulse disturbance weighting characteristic should be constant.

4. Rectifier circuit according to claim 1 or 2,
**characterised in that**
for the weighting of disturbances for protection of GSM systems, the cut-off frequency (f_{c2}) is chosen between 5 Hz and 2 kHz, preferably 1 kHz.

5. Rectifier circuit according to one of the preceding claims,
**characterised in that**
a second peak value rectifier (PK2) is arranged at the output of the linear average value rectifier (AV) with a time constant according to the CISPR standard.

6. Rectifier circuit according to one of the preceding claims,
**characterised in that**
the rectifiers (PK1, RMS, AV, PK2) which are connected in cascade are realised as digital circuits.

## Revendications

1. Circuit redresseur destiné à évaluer l'impact de perturbations impulsives sur des systèmes radio numériques, comportant un circuit en cascade composé d'un redresseur de valeurs efficaces (RMS) et d'un redresseur de valeurs moyennes (AV) linéaire,
**caractérisé en ce que**
un premier redresseur de valeurs de crête (PK1) est monté en cascade en amont du redresseur de valeurs efficaces (RMS).

2. Circuit redresseur selon la revendication 1,
**caractérisé en ce que**
le temps d'intégration T₂ du redresseur de valeurs efficaces (RMS) est limité à une valeur T₂ = 1/f_{c2}, dans lequel f_{c2} est la fréquence de coupure sous laquelle le redresseur de valeurs efficaces (RMS) évalue que les perturbations impulsives sont trop élevées.

3. Circuit redresseur selon la revendication 1 ou 2,
**caractérisé en ce que**
le temps de mesure maximal T₁ du redresseur de valeurs de crête (PK1) est égal à T₁ = 1/f_{c1}, dans lequel f_{c1} est la fréquence de coupure sous laquelle la courbe d'évaluation des perturbations impulsives doit être constante.

4. Circuit redresseur selon la revendication 1 ou 2,
**caractérisé en ce que**
pour l'évaluation des perturbations, la fréquence de coupure (f_{c2}) est choisie entre 5 Hz et 2 kHz, de préférence égale à 1 kHz, afin de protéger les systèmes GSM.

5. Circuit redresseur selon l'une des revendications précédentes,
**caractérisé en ce que**
un second redresseur de valeurs de crête (PK2) est monté à la sortie du redresseur de valeurs moyennes (AV) linéaire avec une constante de temps conforme à la norme CISPR.

6. Circuit redresseur selon l'une des revendications précédentes,
**caractérisé en ce que**
les redresseurs (PK1, RMS, AV, PK2) montés en cascade sont réalisés sous forme de circuits numériques.
